# EUROPEAN PATENT APPLICATION

(11) **EP 1 477 511 A1**
(43) Date of publication of application: **17.11.2004**
(21) Application number: 03076481.5
(22) Date of filing: 15.05.2003
(51) Int. Cl.: C08G 75/04, C08G 18/83, C08G 18/67

(54) **Radiation curable thiol-ene composition**

(71) Applicant: DSM IP Assets B.V., 6411 TE Heerlen (NL)
(72) Inventor: Dias, Aylvin Jorge Angelo Athanasius, 6221 JD Maastricht (NL); Houben, Erwin Johannes Elisabeth, 6211 EB Maastricht (NL); Steeman, Paulus Antonius Maria, 6166 JR Geleen (NL); Wei, Huanyu, 230001 Hefei (CN)
(74) Representative: den Hartog, Jeroen Hendrikus Joseph

(57) **Abstract**

The invention relates to a curable thiol-ene composition comprising either compound A and compound B, or a compound B further comprising polythiol functionality as defined under (A), wherein
(A) a polythiol,
(B) a compound having a plurality of cyclic ene groups thereon, wherein said compound (B) comprises a carbonyl group directly attached to at least one cyclic ene group and comprises at least one hydrogen donating group, wherein the distance between at least one of said cyclic ene groups and at least one of said hydrogen donating groups is at least two skeletal bonds, and
(C) 0-10 wt.% of a (free-radical) photoinitiator.

The invention further relates to the use of such composition fiber optical coating, stereolithography resin, medical coating and adhesive.

## Description

### Field of the Invention

The present invention relates to a curable thiol-ene composition. The invention further relates to a compound having a plurality of cyclic ene groups thereof, to a process for making said compound and said curable thiol-ene composition. Furthermore the invention relates to the use of said composition as a coating composition for optical fibers, as a stereolithographic composition, as a coating or adhesive for optical media, or as a medical coating or as a hard scratch resistant coating.

### Description of related art

Thiol-ene photopolymers are reactive compositions based on the stoichiometric reaction of olefins (`enes', alkenes etc.) and thiols (mercaptans), which polymerize on exposure to UV or VIS light or electron beam (EB) radiation. The polymerisation can also be initiated by peroxides and with thermal initiators. Thiol-ene polymerisations proceed by a step growth addition mechanism that is propagated by a free-radical chain transfer process.

Thiol-ene compositions are well-known in the art. For example, Chapter 7 "Thiol-Ene Photopolymers" by A.F. Jacobine of textbook 'Radiation Curing in Polymer Science and Technology, Volume III, Polymerisation Mechanisms, Editors J.P. Fouassier and J. F. Rabek. describes thiol-ene photopolymers, the mechanism of the thiol-ene reaction, polymerization studies of thiol-ene photopolymers and their application in coatings for optical fibers.

WO 95/00869 (Loctite Corporation) discloses the use of thiol-ene formulations based on norbornene functional polyenes as optical fiber primary coatings. The compositions are characterized by use of a backbone of poly(tetramethylene oxide) in one of the compounds having either a norbornene or a thiol functionality. The compositions are said to be easy applied, to have a relatively low viscosity and to cure substantially completely with very low irradiation fluence.

However, the compositions disclosed in WO 95/00869 appear not to have the required cure speed, appear to be elaborate in their preparation, are too low in viscosity or have a heavy smell rendering such compound unsuitable for industrial purposes.

It is an object of the present invention to provide a curable thiol-ene composition excelling in cure speed, being defined in terms of development of mechanical properties and/or reactive group conversion.

It is a further object of the invention to provide a compound having a plurality of cyclic ene groups that can be relatively easily and practically synthesized and provides a high cure speed when used in a thiol-ene composition.

It is a further object of the present invention to provide coatings suitable in the optical glass fiber industry, more in particular, to a primary optical fiber coating composition having sufficient high cure speed while having a low modulus, and to products obtained therewith.

It is a further object of the invention to provide a curable resin useful for application in the field of stereolithography, optical media, hard coats, the medical area and other area's.

### Summary of the invention

Surprisingly, one or more of the above objects can be obtained by a curable thiol-ene composition comprising either compound A and compound B, or a compound B further comprising polythiol functionality as defined under (A), wherein
(A) a polythiol,
(B) a compound having a plurality of cyclic ene groups thereon, wherein said compound (B) comprises a carbonyl group directly attached to at least one cyclic ene group and further comprises of at least one hydrogen donating group, wherein the distance between at least one of said cyclic ene groups and at least one of said hydrogen donating groups is at least two skeletal bonds, and
(C) 0-10 wt.% of a (free-radical) photoinitiator.

Surprisingly, the ene compound (B) was found not to produce a strong smell, and was found to show the required fast crosslinking reaction with the thiol compound (A) both in terms of chemical polymerization and the development of modulus.

The same improvements can be obtained if compound (B) also comprises polythiol functionality.

The improvement found by the present inventors is applicable in many radiation curable compositions, but is particularly suitable in fiber optic technology, adhesives and coatings for optical readable disks, hard coatings and radiotion curable resins for stereolithography, as these fields of technology require high cure speed and/or high light sensitivity, and/or low shrinkage. The improvement is further applicable in medical coatings. For medical coatings, it is preferred that the composition comprises a compound wherein (A) and (B) are both present.

### Figures

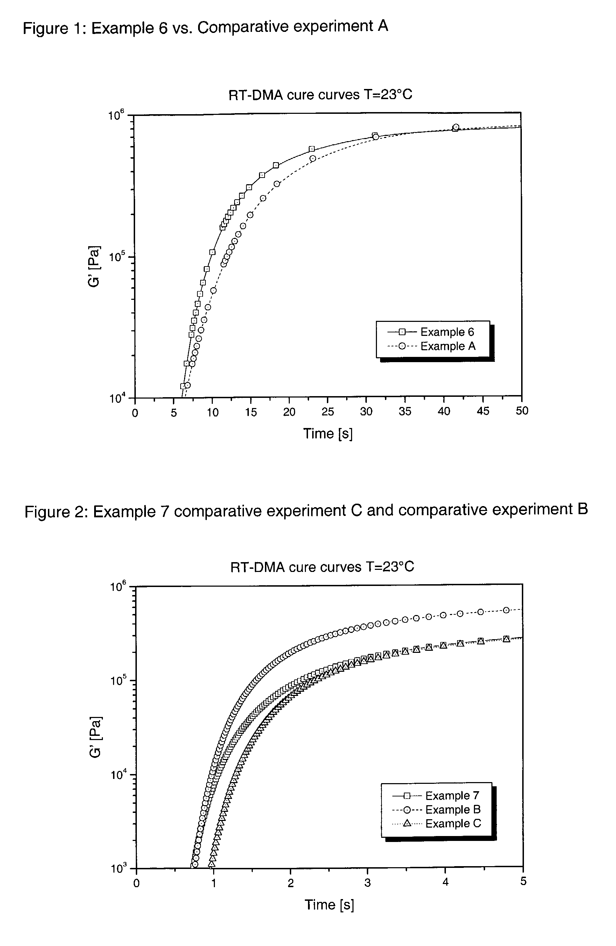

Figure 1-3 give RT-DMA plots of a number of examples and comparative experiments.

### Detailed description of the invention

The description below exemplifies the embodiment in which (A) and (B) are separate compounds. Nevertheless, the same teaching applies for compounds comprising both (A) and (B) functionality.

The components A and B should have functionality such that a crosslinked polymer results from its polymerisation. Therefore, the functionality of each reactive component (the ene and the thiol) must be on average larger than one, and the functionality in total preferably is four or higher for a high-molecular weight cross-linked polymer to be produced. The functionality of A + B in total may be slightly lower than 4, for example above 3.5, if a cross-linking compound is part of the composition. Examples of such cross-linking compounds are polyacrylates like trimethylol propane triacrylate, hexandioldiacrylate, triallyl functional compounds and the like.

In order for components A and B to have an average functionality larger than 1, each component will comprise at least two-functional molecules.

Generally, the average functionality of each components A and B is about 1.2 or higher. Preferably, the average functionality of each component A and B is about 1.8 or higher, whereas the functionality of A and B together is about 4 or higher. More preferably, the functionality of A and B together is 4.5 or higher. Generally, the functionality of A plus B is 10 or lower, preferably 7 or lower.

The ratio of the polyene component (B) to the polythiol component (A) can be varied within a range such that the molar ratio of ene to thiol groups is from about 1.0:0.8 to about 1.0:1.5.

A thiol content below about 1.0:0.8, ene/thiol, in the formulation may not give a composition curable with the desired low energy input. Thiol content above a ratio of about 1.0:1.3, ene/thiol, possibly as high as 1.0:1.5 may be satisfactory in some instances. Generally, it is preferred that the ratio of ene to thiol groups be about 1:1. However in spite of the above given ratios, altered ratios can be used if additional unsaturated groups eg acrylates or vinylethers are used to alter the speed of polymerisation, mechanical properties, or other characteristics.

While a preferred curable composition using cyclic ene functional compounds of the invention may include both difunctional cyclic ene functional compounds and difunctional thiol compounds, it will be understood that at least a portion of at least one of these components preferably contains more than two functional groups per molecule to produce a crosslinked product when cured. That is, the total of the average number of cyclic ene groups per molecule of ene functional compound (B) and the average number of coreactive thiol groups per molecule of the thiol functional compound (A) should preferably be greater than 4 when a crosslinked cured product is desired.

In the curable thiol-ene composition according to the present invention, either one of compound (A) or (B) preferably contains a backbone, said backbone having a molecular weight ranging from 250 to 10,000, preferably, from 500 to 6,000, more preferably from 750 to 5,000 and most preferred from 1,000 to 4,000.

The term backbone is used to denote an oligomer or polymeric part in a compound to which the remainder of the molecule is attached. The oligomer or polymer contains repeating units as will be explained and examplified further below.

According to one embodiment of the present invention, compound (A) contains at least three functional thiol groups; and compound (B) contains two cyclic ene functional groups and a backbone.

Alternative formulations within the scope of the present invention employ a compound (A) containing two functional thiol groups and a backbone; and a compound (B) containing at least three cyclic ene functional groups.

### Component (A)

As the polythiol component (A) any compound can be used which comprises molecules having two or more thiol groups per molecule. Preferably the average functionality is 1.8 or higher, more in particular about 2 or higher. Compatibility with the cyclic ene-functional compound (B) is preferred in order to maintain shelf stability of the formulation. Polythiol ingredients may be any of those known in the art. A description of the most common thiol compounds may be found at column 9, lines 1-41 of U.S. Pat. No. 3,661,744, which is incorporated herein by reference. Certain polythiols such as the aliphatic monomeric polythiols (ethane dithiol, hexamethylene dithiol, decamethylene dithiol, tolylene-2,4-dithiol, and the like, and some polymeric polythiols such as a thiol-terminated ethylcyclohexyl dimercaptan polymer, and the like, and similar polythiols which are conveniently and ordinarily synthesized on a commercial basis, although having obnoxious odors, are operable but many of the end products are not widely accepted from a practical, commercial point of view. Examples of the polythiol compounds preferred because of relatively low odor level include but are not limited to esters of thioglycolic acid (HS-CH₂COOH), α-mercaptopropionic acid (HS-CH(CH₃)-COOH and β-mercaptopropionic acid (HS-CH₂CH₂COOH) with polyhydroxy compounds such as glycols, triols, tetraols, pentaols, hexaols, and the like. Specific examples of the preferred polythiols include but are not limited to ethylene glycol bis(thioglycolate), ethylene glycol bis (β-mercaptopropionate), trimethylolpropane tris(thioglycolate), trimethylolpropane tris (β-mercaptopropionate), pentaerythritol tetrakis (β-mercaptopropionate), all of which are commercially available. A specific example of a preferred polymeric polythiol is polypropylene ether glycol bis(β-mercaptopropionate) which is prepared from polypropylene-ether glycol (e.g. Pluracol P201, Wyandotte Chemical Corp.) and β-mercaptopropionic acid by esterfication. Poly-α-mercaptoacetate or poly-β-mercaptopropionate esters, particularly the trimethylopropane triesters or pentaerythritol tetra esters are preferred. Other polythiols which can be suitably employed include alkyl thiol functional compounds such as 1,2-dimercapthoethane, 1,6-dimercaptohexane and the like. Thiol terminated polysulfide resins may also be employed.

Suitable examples of aliphatic dithiols include 1,2-ethanedithiol, butanedithiol, 1,3-propanedithiol, 1,5-pentanedithiol, 2,3-dimercapto-1-propanol, dithioerythritol, 3,6-dioxa-1,8-octanedithiol, 1,8-octanedithiol hexanedithiol, dithiodiglycol, pentanedithiol,decanedithiol, 2-methyl 1,4 butanedithiol, bis-mercaptoethylphenyl methane, 1,9-nonanedithiol(1,9-dimercaptononane), glycol dimercaptoacetate.

Suitable examples of aromatic dithiols include 1,2-benzenedithiol, 1,3-benzenedithiol, 1,4-benzenedithiol, 2,4,6-trimethyl-1,3-benzenedimethanethiol, durene-α1, α2-dithiol, 3,4-dimercaptotoluene, 4-methyl-1,2-benzenedithiol, 2,5-dimercapto-1,3,4-thiadiazole, 4,4'-thiobisbezenedithiol, bis(4-mercaptophenyl)-2,2'-propane(bisphenol dithiol) (made according to the method of Meng Y.Z., Hay. A.S., J. of App. Polym. Sci., V74, 3069-3077(1999).

Suitable examples of oligomeric dithiols include difunctional mercapto functional urethane oligomers derived from end capping moieties of hydroxyethyl mercaptan, hydroxypropyl mercaptan, dimercaptopropane, dimercapto ethane as described in patent by Shustack USP 5744514.

Examples of suitable trithiol functional compounds include, trimethylolethane tris-mercaptopropionate, trimethylolpropane tris-mercaptopropionate (TMPTSH), trimethylolethane tris-mercaptoacetate, and trimethylolpropane tris-mercaptoaacetate glycerol tri(11-mercaptoundecanoate), trimethylol propane tri(11-mercaptoundecate). A preferred trithiol is trimethylolpropane tris(2-mercapto-propionate) TMPTSH.

Examples of suitable tetrafunctional thiols include pentaerythritol tetramercapto propionate, pentaerythritol tetramercapto acetate, and pentathritoitetra(11-mercaptoundecate)

Examples of multifunctional thiols having functionality greater than 4, include polythiols as described on page 7 of Loctite patent of (WO/88 02902).

Multi functional thiols can be obtained by reacting thioalkyl carboxylic acids eg thioglycolic acid, mercapto propionic acid with high functional alcohols, amines and thiols. Furthermore, multifunctional thiols can be obtained by reacting mercapto alkyl trialkoxy silanes with silanols that may be polymeric or silica based silanols.

Other preferred multifunctional thiols are obtained using thiol carboxylic acids (HS-R-COOH) where R = alkyl, or aryl groups eg thioundecanoic acid of which the COOH groups are reacted with reactive enes, alcohols, thiols or amines that are multifunctional

### Component (B)

As the compound (B), any compound can be used which comprises molecules having two or more cyclic ene functional groups, thereon, wherein said compound comprises a carbonyl group directly attached to at least one cyclic ene group, and further comprises at least one hydrogen donating group, wherein the distance between the at least one of said cyclic ene groups and at least one of said hydrogen donating groups is at least two skeletal bonds.

Preferably, the average functionality is 1.8 or higher, more in particular about 2 or higher.

According to one preferred embodiment, compound (B) has a molecular weight between 500-10,000 and contains a plurality of ene functional groups and at least one hydrogen donating group, wherein compound (B) contains at least two skeletal bonds between the ene group and the hydrogen donating group.

The term "hydrogen donating group" as used herein refers to a hydrogen that is able to form reversible (inter- or intramolecular) physical interactions with another atom or group. Examples of such physical interactions are hydrogen bridge forming or hydrogen donating ability. The hydrogen bond donating species is the most influential species since in most examples this is the lower concentration i.e there are many C=O hydrogen accepting species in the system. Preferably, said hydrogen donating group is selected from the list consisting of hydroxy (OH), amino (NH, NH₂), SH, carboxyl - eg COOH, COSH. More preferably, said hydrogen donating group is OH or NH. More preferably, said group can be derived from a urethane (carabamate) group, inverted urethanes, an urea group, an amide group, thio-urethane , thiourea, isothiourea, hydroxy esters, hydroxy and the like. Most preferred are urethane groups.

The skeletal bonds may contain atoms selected from the group consisting of carbon, oxygen, nitrogen, sulfur, phosphorous, boron or silicon. Preferably, the skeletal bonds are carbon bonds, such as, for example, ethyl, propyl, butyl, and the like. Most preferably, the group between the ene and hydrogen donating group is an ester-ethyl group.

The ene functional group in an embodiment of the invention is a cyclic ene group. A cyclic ene group can be a cycloalkenyl with 4-20 carbon atoms, and comprises a single cyclic, multi cyclic, and preferably comprises a fused multi cyclic structure. The cyclo alkenyl can comprise one or more unsaturated bonds. The cyclic ene group can contain hetero atoms like sulphur, oxygen and nitrogen, thus maybe in the form of ether, ester thioether, and amine functionality.

Preferably, the ene functional group can be selected from the group cyclopentene, cyclohexene, norbornene, and other fused ring structures. The double bond preferably is at the γ-position with respect to the carbonyl.

The cyclic ene group includes but is not limited to compounds derived from Diels Alder reactions of dienes with the formula below 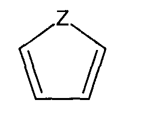 where Z is CH₂, O, N,NR, S, SO₂, CHCH₃, C(CH₃)₂. Other higher carbon content ring structure eg cyclohexadiene, cyclooctadiene and hetero atom analogues of the 5 atom ring given above may also be used.

Cyclic enes that result from Diels Alder type additions are preferred. Suitable dienes which can be used include cyclopentadiene, cyclooctadiene, hexadiene, furan, thiophene, pyran.

The above mentioned dienes can be reacted to result in cyclic enes by addition to unsaturated groups like (meth)acrylates, fumarate, maleate, itaconate, maleimide, crotonic acid, and other electron poor double bonds.

The ene termination of compound (B) can be obtained in a variety of ways.

According to one preferred embodiment of the present invention, the compound (B) is obtained by reacting an oligomer (B1) being a urethane (meth)acrylate oligomer, comprising a (meth)acrylate group, urethane groups and a backbone. (Meth)acrylate includes acrylate as well as methacrylate functionality. The backbone is derived from a polyol which has been reacted with a diisocyanate and hydroxy alkyl acrylate or hydroxy alkyl methacrylate with (B2) a cyclopentadiene compound.

The reaction can be carried out without or in the presence of a solvent. In general, a solvent is not necessary when the acrylate oligomer (B1) has sufficiently low viscosity at the reaction. Examples of suitable solvents include but are not limited to toluene, xylene, hexane, heptane, THF, dioxane, dimethyl sulfoxide, dimethyl formamide and water. The reaction is preferably carried out under a nitrogen atmosphere.

The cyclopentadiene compound (B2) can be obtained by cracking dicyclopentadiene (DCPD) at temperatures ranging from 130 to 260°C, preferably from 150 to 240°C. Preferably, freshly cracked cyclopentadiene monomer (B2) is reacted with oligomer (B1 ) The reaction temperature can range from 20°C to 120°C, preferably, from 30 to 100°C. The reaction temperature can range from 8 to 20 hours, preferably from 10 to 16 hours. Excessive cyclopentadiene and dicyclopentadiene can be removed under vacuum pressure at temperatures typically ranging from 30 to 80°C. Alternatively dicyclopentadiene may be cracked in situ in the presence of an oligomer or polymer at a temperature of from 130°C to 260°C.

The (B1) a urethane (meth)acrylate oligomer can be prepared by reacting
(i) a polyol,
(ii) a polyisocyanate, and
(iii) an hydroxyfunctional endcapping compound capable of providing at least one (meth)acrylate terminus.

Examples of suitable polyols are polyether polyols, polyester polyols, alkyd polyols, polyhydrocarbon polyols, polycarbonate polyols, polycaprolactone polyols, polyhydroxalkanoate (like polylacticacid), acrylic polyols, polysiloxane polyols, halogenated polyols, polyurethane polyols, and the like. These polyols may be used either individually or in combinations of two or more. Preferred are polyether urethane acrylate oligomers, even more preferred are aliphatic polyether urethane acrylate oligomers. The term "aliphatic" refers to a wholly aliphatic polyisocyanate used. There are no specific limitations to the manner of polymerization of the structural units in these polyols. Any of random polymerization, block polymerization, or graft polymerization is acceptable. Examples of suitable polyols, polyisocyanates and hydroxylgroup-containing (meth)acrylates are disclosed in WO 00/18696, which is incorporated herein by reference.

The polyols generally have an average functionality of about 1.8 or higher, preferably about 2 or higher, and generally about 10 or lower, preferably 5 or lower.

The reduced number average molecular weight derived from the hydroxyl number of these polyols is usually from about 50 to about 25,000, preferably from about 500 to about 15,000, more preferably from about 1,000 to about 8,000, and most preferred, from about 1,500 to 6,000.

The ratio of polyol, di- or polyisocyanate (as disclosed in WO 00/18696), and hydroxyl group-containing (meth)acrylate used for preparing the urethane (meth)acrylate is determined so that about 1.1 to about 3 equivalents of an isocyanate group included in the polyisocyanate and about 0.1 to about 1.5 equivalents of a hydroxyl group included in the hydroxyl group-containing (meth)acrylate are used for one equivalent of the hydroxyl group included in the polyol.

In stead of the hydroxyalkyl(meth)acrylate, one can use eg butyl-hydroxyethylfumarate, ethyl-hydroxyethylmaleate, butyl-hydroxypropylitaconate, propyl-hydroxypropylmaleimide, hydroxyethylcrotonate. It is also possible to use bis-hydroxyethylmaleate in order to create cyclic-ene side chains.

In the reaction of these three components, a catalyst such as copper naphthenate, cobalt naphthenate, zinc naphthenate, di-n-butyl tin dilaurate, triethylamine, and triethylenediamine, 2-methyltriethyleneamine, is usually used in an amount from about 0.01 to about 1 wt% of the total amount of the reactant. The reaction is carried out at a temperature from about 10 to about 90°C, and preferably from about 30 to about 80°C.

The number average molecular weight of the urethane (meth)acrylate (B1) used in the composition of the present invention is preferably in the range from about 300 to about 20,000, and more preferably from about 500 to about 10,000. The number average molecular weight of the urethane (meth)acrylate is preferably higher than about 1000 if the resin composition is to be used in compositions with a low modulus (i.e. < 10 MPa). If the number average molecular weight is larger than about 20,000, the viscosity of the composition becomes high, making handling of the composition difficult.

The synthesis is known in the art, and can proceed via several steps. For example, a convergent synthesis in an out-side-in approach with reaction of disocyanate with hydroxyacrylates first followed by addition of polyol or divergently (inside out aprroach). Reaction of polyol with diisocyanate first, and thereafter with the hydroxyalkylacrylate (or another hydroxy functional compound having an electron poor double bond).

Further convenient ways to make compound (B) are by reacting an hydroxy terminated compound (a polyol or diol) with hydroxy reactive cyclic ene functional compounds such as acid chlorides, isocyanates, azlactones and chloroformates. The choice of linkage does influence the properties obtained.

In another preferred embodiment of the present invention, compound B is obtained by reacting epoxyacrylate mono- or oligomers with cyclopentadiene. Suitable epoxyacrylate mono- or oligomers include bisphenol-A diglycidyldiacrylate (monomer), and oligomeric bisphenol-A diepoxydiacrylates. Hence, this compound B comprises a cyclic ene group, a carbonyl next to the cyclic ene group, and a hydroxy group as hydrogen donating group.

In yet another preferred embodiment, the compound B is a compound derived from acrylated polyesters or from fumarate based unsaturated polyesters. Himic and DCPD resins are in particular useful for resins that are used in applications with high modulus or green strength like in stereolithography.

### Compound (B-A)

A compound (B) which further comprises polythiol functionality [i.e. compound (B-A)] can be made in several ways. One skilled in the art can for example react cyclopentadiene with a compound comprising one or more ethylenically unsaturated groups and one or more thiol groups. Another suitable way comprises reacting first cyclopentadiene with e.g. hydroxyethylacrylate, and thereafter reacting this addition product and a mercaptoalkyl alcohol with a multifunctional isocyanate, preferably three or more functional isocyanate compound. For example a three functional polyethyleneglycol (like the hydroxy terminated 3-arm PEG (P2223 or P2229) from Polymer Source USA) can be reacted with 3 moles of TDI. The resulting 3 functional isocyanate compound can be reacted with 1 ½ moles of mercapto ethanol and 1 ½ moles of the addition product of cyclopentadiene and hydroxyethylacrylate. A diluent with both a mercapto and a norbornene functionality which can be used is the addition product of cyclopentadiene with 3-mercaptopropylacrylate.

### Component (C)

Compositions formulated for electron beam (EB) curing do not require a cure initiator. Compositions formulated for UV-vis or thermal cure will desirably include a photoinitiator or thermal initiator, respectively. The initiator may be radical or cationic. Most suitable is a free radical photoinitiator. Examples of free radical photoinitiators or maleimide photoinitiators are descibed by Dias et. al.(Suface Coatings International, JOCCA 2000, 10, 502-506 and WO-01/27040).

Optionally the system may be used without photoinitiator in a manner analogous to that described by Bowman where special UV light sources with strong emissions centred around 254nm ( Bowman et. at. Macromolecules 2002, 35, 5361-5365) and with use of maleimides as described in EP0618237.

The photoinitiator (C) is employed in an amount effective for initiating cure of the formulation, typically ranging from 0.1 to 10 wt.% relative to the total weight % of the composition, preferably from 0.5 to 8 wt.%, more preferred from 1 to 5 wt.%. Combinations of two or more photoinitiators may also be employed.

### Further components and properties

The thiol-ene compounds (A+B+ optionally C) of the present invention may be present in the composition in an amount of about 5 wt% or more preferably about 10 wt% or more, more preferably about 20 wt% or more, even more preferably about 30 wt.% or more and most preferably about 40 wt% or more. The thiol-ene compounds [A+B+ optionally C] may consitute the entire composition, but can also be present in an amount of about 99 wt% or less and often will be present in an amount of 90 wt% or less. The amount is not critical, and can be about 80 wt% or less or about 70 wt% or less.

Besides the thiol-ene compounds [A+B], the composition of the present invention may also contain other oligomers or reactive diluents with unsaturation capable of reacting with thiol groups. These reactive oligomers or diluents can comprise ene groups such as for example allyl, vinyl, acrylate and cyclic ene groups. In one preferred embodiment of the present invention at least one oligomer or diluent is used with a cyclic ene group. Oligomers with cyclic ene groups are for example norbonene functional alkoxylated bisphenol - A, norbornene functional polyesters or norbornene functional polyethers. These oligomers can be made by addition of cyclopentadiene to acrylate functional oligomers, other than the oligomers rendering such addition product an oligomer compound (B). As diluents it is possible to use Diels alder adducts of low molecular weight acrylates and methacrylates, fumarates and maleates and other analogous, which are preferably multifunctional. Suitable examples are the cyclopentadiene addition products of diethylene glycoldiacrylate, alkoxylated trimethylolpropane triacrylate and the like.

Other types of oligomers can be present as well, such as for example, (meth)acrylate, epoxy, hydroxy or other functional oligomers, preferably urethane (meth)acrylate oligomers as described as (B1) above. Commercial urethane acrylates can include but are not limited to CN934, CN961, CN962, CN964, CN965, CN980 (from Sartomer). Suitable other acrylate functional oligomers include epoxy (meth)acrylates, such as CN104, CN115, CN117, CN120, CN124, CN151 and polyester(meth)acrylates. Epoxy functional compounds are also well known in the art.

Any other oligomer may be present in the composition of the present invention in an amount ranging from 0.01 wt% - 50 wt%. Oligomers and particles which can be reactive or non-reactive with respect to compounds A and/or B can be used to achieve certain properties as viscosity, color, hardness, reflective index and the like.

Reactive diluents may be present as well. In case of acrylate oligomer, well known acrylate functional diluents can be used.

The formulations also preferably include a stabilizer. Preferred stabilizers, described in EP 428,342 incroporated herein by reference, are non-acidic nitroso compounds, particularly N-nitrosohydroxylarylamines and derivatives thereof. Alternatively, the formulation may be stabilized with a stabilizer system comprising an alkenyl substituted phenolic compound and one or more compounds selected from the consisting of a free radical scavenger, a hindered phenolic antioxidant and a hydroxylamine derivative. Examples of suitable alkenyl substituted phenolic compounds include 2-propenylphenol, 4-acetoxy styrene, 2 allylphenol, isoeugenol, 2-ethoxy-5-propenylphenol, 2-allyl-4-methyl-6-*t*-butylphenol, 2-propenyl-4-methyl-6-*t*-butylphenol, 2-allyl-4,6-di-*t*-butylphenol, 2-propenyl-4,6-di-*t*-butylphenol and 2,2'-diallyl-bisphenol A, suitably at levels of 500 ppm - 5000 ppm by weight of the composition. Preferably the alkenyl phenolic compound is used with a N-nitroarylhydroxylamine salt, a radical scavenger such as *p*-methoxy phenol (MEHQ), and a hindered phenolic antioxidant such as butylated hydroxy toluene (BHT).

The composition can contain an adhesion promotor, such as mercapto alkoxysilanes and Diels alder adducts of the acrylated alkoxysilanes as well as the more common organofunctional organosilane adhesion promoters.

Mechanical properties of the cured compositions can vary within broad ranges. The modulus (E') at 25°C can be low, i.e. between 0.5-2 MPa, or higher, up to 4 GPa. The compositions of the present invention have advantages, for example a high cure speed combined with low modulus, or, at high modulus (100-2000 MPa) better material properties like improved ultimate tensile properties like stress and strain at break.

The composition of the present invention may be used as a coating for optical fibers and may be colored or not. The composition may be used as an optical fiber primary or secondary coating, as an ink composition or as a matrix material. Preferably, the composition is used as a primary coating.

Commonly, glass optical fibers are provided with protective coatings immediately after spinning the molten glass. Generally, two coatings are applied, a primary coating of a relatively soft, flexible resin directly on the glass surface, and a harder resin, a secondary coating, on the primary coating. However, it is also possible to use a single coating instead of a primary and a secondary coating. The individual fibers generally are combined in larger structures such as cables. Cables may comprise individual fibers, or fiber ribbon structures. The optical fiber ribbon generally is made from 2, 4, 6, 8 or 12 optical fibers, generally arranged in a plane, and bonded together with a so-called matrix material. Several ribbons can be bundled together using bundling materials or encapsulating matrix materials. Further, individual fibers often are provided with a coloring or ink layer to be able to identify individual fibers. In certain cases, the individually coated fibers that have a thickness of about 250 µm are provided with a further coating layer to make a thicker and thereby more easy to handle fiber. Such a coating is denoted as an upjacketing coating. All of the materials presently in use for these applications are preferably radiation curable compositions.

The primary coating serves as a buffer to cushion and protect the fiber by relieving the stresses created when the fiber is bent, cabled or spooled. Such stress might otherwise induce microbending of the fibers and cause attenuation of the light travelling through them, resulting in inefficient signal transmission. When optical fibers are coated with a primary coating material having an equilibrium modulus of about 2 MPa or higher, the transmission loss of the optical fibers may increase because of decreased buffering effect. A material having a low modulus of elasticity (e.g. an equilibrium modulus of 1.5 MPa or less) is, therefore, desirable as the primary coating material. Additionally, one of the most important characteristics required nowadays for curable resins used as coating materials (for protective or identification purposes) for optical fibers is to have a cure speed that is sufficiently high to be applicable at the currently used increasing optical fiber drawing speeds while still being cured thoroughly and without sacrificing the chemical and mechanical properties of the cured coating.

The use of the presently invented composition as a primary coating combines excellent material properties at low modulus, combined with a relatively high cure speed.

The composition may further be used in stereolithography or photofabrication.

In recent years, photofabrication of three-dimensional objects made from cured resin layers integrally laminated by repeating a step of selectively irridiating a photocurable resin composition has been proposed (see for example U.S. Patent No. 4,575,330).

A typical example of such photofabrication is as follows. The surface of a photocurable resin composition (a liquid material) in a vessel is selectively irradiated with light from an ultraviolet laser and the like based on CAD data to form a cured resin layer having a specified pattern. Then, an uncured layer of a resin composition is provided over this cured resin layer and the liquid surface is selectively irradiated to form a new cured resin layer integrally laminated over the cured resin layer. This step is repeated a certain number of times using the same or different irradiating patterns to obtain a three-dimensional object consisting of integrally laminated cured resin layers. The object preferably is washed with a washing agent to remove excess resin sticking to the surface of the object, and the object preferably is postcured by for example UV or heat to further improve the mechanical properties of the object. This photofabrication has attracted considerable attention because a three-dimensional object having a complicated shape can be easily formed in a short period of time.

In stereolithographic (or photofabrication) applications, it is important to ensure that there is minimal shrinkage and more importantly minimal stresses that cause distortion of the fabricated parts. The compositions of the present invention have excellent properties, i.e. very low shrinkage, combined with good material properties.

Cured compositions can be obtained with a modulus of 100-2000 MPa, with a relatively high strain at break and stress at break, making these products particularly suitable as functional prototypes.

Preferably, the thiol-ene compositions of the present invention are used together with high Tg monomers, oligomers and fillers to further improve or to change the basic mechanical properties of the thiol-ene compositions. The stereolithographic compositions, so obtained, also show a sufficiently low shrinkage.

Further, the thiol-ene compositions of the present invention may be suitably used in optical media applications (such as CD coatings, DVD adhesives), resulting in a good adhesion.

Finally, the thiol-ene compositions of the present invention can be used in medical coatings as they have the advantage of low toxicity due to avoidance of toxic acrylates. Such thiol-ene products also show improved compatability with biological tissue. For medical coatings it is preferred to use compounds with both thiols and compound (B) functionality.

The invention will be further elucidated by the following examples and test methods.

### Examples and Comparative Experiments

### List of abbreviations used:

All molecular weights are given in g/mol.

PPG2000 is polypropylene glycol having a molecular weight of about 2000, supplied by Bayer.

PPG4200 is polypropylene glycol having a molecular weight of about 4200, supplied by Bayer.

PTG-L 2000 is 2000 MW poly (tetramethylene glycol) with 5-15% 3-methyl substituted PTMG to reduce crystallinity from Hodogaya Chemical Co. in Japan.
IPDI is isophorone diisocyanate
HEA is 2-hydroxyethylacrylate
HPA is 3-hydroxypropylacrylate (Aldrich)
HBA is 4-hydroxybutylacrylate (Aldrich)
NB is norbornene
Irgacure 184 is hydroxylcyclohexyl phenyl ketone, a photoinitiator supplied by Ciba Geigy
TMPTSH is trimethylolpropane tris(3-mercapto-propionate), theoretical molecular weight 399, supplied by Aldrich or Evans Chemetics.
TTLSH is Pentaerithritol tetra(11-mercapto-undecanoate) (theoretical molecular weight 937.5), is made by esterification of pentaerithritol with 11-mercapto-undecanoic acid. These are higher molecular weight multifunctional thiols and they are useful for applications where the elimination of the odour of thiols is important, e.g. for use in stereolithography.
PETMP is pentaerithritol tetrakis (3-mercapto-propionate) supplied by Bock Thiochemicals Germany.
ENPA is ethoxylated nonyl phenol acrylate (SR504), supplied by Sartomer
DEGEHA is di(ethylene glycol)-2-ethyl hexyl acrylate, supplied by Aldrich

### Dicyclopentadiene (DCPD) cracking

I00g paraffin was placed in a 250mL three-necked round-bottomed flask fitted with a large (about 30cm) Vigreux column, a dropping funnel and a thermometer dipping into the paraffin. A distillation head was attached carrying a thermometer and a double surface condenser arranged for distillation. The paraffin was heated to 200-240°C (salt bath) and dicyclopentadiene (DCPD) was added portionwise, from the dropping funnel. Cyclopentadiene was collected with a b.p. 40-42°C, in a cooled receiver, protected from moisture. The dicyclopentadiene was added slowly to ensure complete breakdown of the dimer; the temperature at the top of the distillation-head rises above 42°C when addition is too rapid. The diene dimerises readily at room temperature, hence it was used immediately or stored in the ice compartment of a refrigerator overnight.

### Example 1 Synthesis of a PTGL 2000 Urethane Dinorbornene oligomer

The acrylate oligomer PTGL2000 Urethane Diacrylate (made from PTGL2000 diol, IPDI and HEA) 20 g (0.008 mol) was dissolved into 15 ml toluene and stirred at 40°C under a nitrogen atmosphere in a 250 ml three-necked round-bottom flask equipped with an efficient condenser, a constant pressure addition funnel, and a thermometer. 1.56g of freshly cracked cyclopentadiene monomer (0.024 mol, 3 equivalents) was added dropwise by addition funnel. The reaction temperature was then raised to 80°C and stirred for about 16 hours (overnight). Finally, excess cyclopentadiene and dicyclopentadiene were removed under vacuum pressure (0.5-2 mbar, below 70°C), to give a quantitative yield of a pale yellow resin. The reaction was followed by FT-IR and ¹H NMR measurement using the spectroscopic peaks given below FT-IR (neat,cm⁻¹): 1722 (urethane carbonyl); 3061.1, 712 (double bond of norbornene)
¹H NMR (CDCI₃, ppm): 5.93, 6.12, 6.18 (*endo* and *exo* hydrogens of norbornene double bonds)

The compound so obtained can be represented by the following chemical structure: 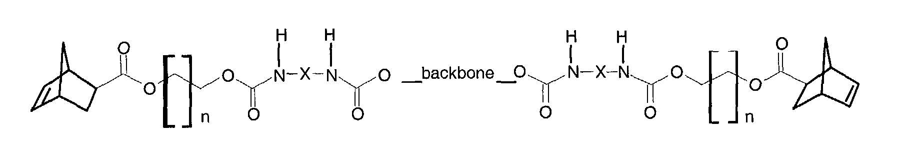 wherein the backbone is PTGL2000, X is derived from IPDI and n equals 1. The compound has a theoretical number average molecular weight Mn of 2809. The compound will be further referred to by PTGL2000-(IPDI-HEA-NB)₂.

### Example 2 Synthesis of PPG 2000 Urethane Dinorbornene

Acrylate oligomer PPG2000 Urethane Diacrylate (made from PPG2000 diol, IPDI and HEA as described in US-A-5837750) 31.4 g (0.008 mol) was dissolved into 10 ml toluene and stirred at 40°C under a nitrogen atmosphere in a 250 ml three-necked round-bottom flask equipped with an efficient condenser, a constant pressure addition funnel, and a thermometer. Freshly cracked cyclopentadiene monomer 1.56g (0.024 mol, 3 equivalents) was added dropwise by addition funnel, then the reaction temperature was raised to 80°C and stirred for about 16 hours (overnight). Finally, excessive cyclopentadiene and dicyclopentadiene were removed under vacuum (0.5-2 mbar, below 70°C), and a slightly yellow resin was yielded quantitatively. Analysis of the reaction mixture by FT-IR and ¹H NMR measurement showed the conversion to be complete. FT-IR (neat, cm⁻¹): 1722(urethane carbonyl), 3061.1, 712 (double bond of norbornene)
¹H NMR (CDCI₃, ppm): 1.15 (-CHCH₃), 3.4 (-CH₂O), 3.57 (-CHCH₃), 5.95, 6.12, 6.17(*endo* and *exo* hydrogens of norbornene double bonds)

The compound so obtained can be represented by the following chemical structure: 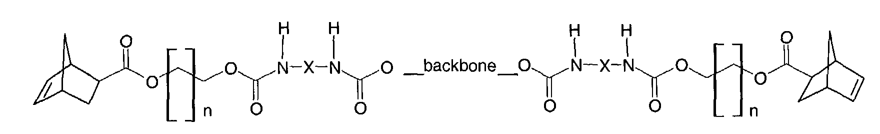 wherein the backbone is PPG2000, X is derived from IPDI and n equals 1. The compound has a theoretical number average molecular weight Mn of 2809 and will be further referred to by PPG2000-(IPDI-HEA-NB)₂.

### Example 3 Synthesis of PPG 4200 Urethane Dinorbornene

The oligomer of Example 3 is prepared in the same way as for Example 2, except that PPG 4200 diol is used instead of PPG 2000 diol. The compound so obtained can be represented by the same chemical structure as given under Example 2, but wherein the backbone is PPG 4200, X is derived from IPDI and n equals 1. The compound has a theoretical number average molecular weight Mn of 5009 and will be further referred to by PPG4200-(IPDI-HEA-NB)₂.

### Example 4 Synthesis of a PPG 2000 Urethane Dinorbornene oligomer

The oligomer of Example 4 is prepared in the same way as for Example 2, except that HPA is used instead of HEA. The compound so obtained can be represented by the same chemical structure as given under Example 2, but wherein the backbone is PPG 2000, X is derived from IPDI and n equals 2. The compound has a theoretical number average molecular weight Mn of 2823 and will be further referred to by PPG 2000-(IPDI-HPA-NB)₂.

### Example 5 Synthesis of a PPG 2000 Urethane Dinorbornene oligomer

The oligomer of Example 5 is prepared in the same way as for Example 2, except that HBA is used instead of HEA. The compound so obtained can be represented by the same chemical structure as given under Example 2, but wherein the backbone is PPG 2000, X is derived from IPDI and n equals 3. The compound has a theoretical number average molecular weight Mn of 2837 and will be further referred to by PPG 2000-(IPDI-HBA-NB)₂.

### Example 6 Thiol-ene composition containing the oligomer of Example 1

A thiol-norbornene coating composition was prepared, by mixing the following materials:

| | |
|---|---|
| [PTGL 2000 (IPDI-HEA-NB)₂] | 20g (90.45 wt.%) |
| Trimethylolpropane tris(3-mercapto-propionate) | 1.89 g (8.55 wt.%) |
| Irgacure 184 | 0.221 g (1.00 wt.%) |

The molar ratio of ene to thiol is 1:1.

The composition was cured and tested in a RT-DMA (run at lower UV intensity at 1.5 mW/cm²) and RT-IR measurement. The composition showed a fast modulus build-up (see Figure 1). Other results are shown in Table 3.

### Example 7 Thiol-ene composition containing the oligomer of Example 2

A thiol-norbornene coating composition was prepared, by mixing the materials as in Example 6, but using [PPG 2000 (IPDI-HEA-NB)₂] as the compound B.

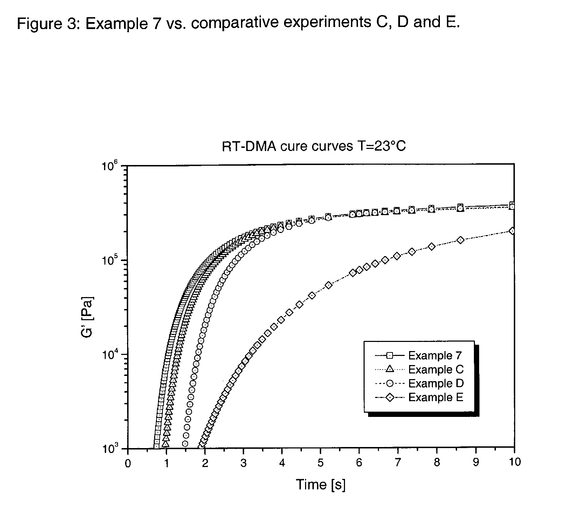

The composition was cured and tested in a RT-DMA and RT-IR measurement. All examples with PPG based oligomers were run (RT-DMA) at a UV intensity of 28 mW/cm². The composition showed a very fast modulus build-up when measured by RT-DMA (see Figures 2 and 3). Other results are shown in Table 2.

### Example 8 Thiol-ene composition containing oligomer of Example 3

A thiol-norbornene coating composition was prepared, by mixing the following materials:

| | |
|---|---|
| [PPG 4200 (IPDI-HEA-NB)₂]; | 20g (94.02 wt.%) |
| Trimethylolpropane tris(3-mercapto-propionate) | 1.06 g (4.98 wt.%) |
| Irgacure 184 | 0.213g (1.00 wt.%) |

The composition was cured and tested in a RT-DMA and RT-IR measurement. Results are shown in Table 1.

### Example 9 Thiol-ene composition containing oligomer of Example 4

A thiol-norbornene coating composition was prepared, by mixing the materials as in Example 6, but using ([PPG 2000 (IPDI-HPA-NB)₂] as the oligomer.

The composition was cured and tested in a RT-DMA and RT-IR measurement. Results are shown in Table 2.

### Example 10 Thiol-ene composition containing oligomer of Example 5

A thiol-norbornene coating composition was prepared, by mixing the materials as in Example 6, but using [PPG 2000 (IPDI-HBA-NB)₂] as the oligomer.

The composition was cured and tested in a RT-DMA and RT-IR measurement. Results are shown in Table 2.

### Example 11 - Thiol-ene composition containing oligomer of Example 3 effect of fuctionality of thiol by using tetrathiol

A thiol-norbornene coating composition was prepared, by mixing the materials as in Example 8, but using 1.87 g Pentaerythritol tetra(11-mercaptoundecanate) as the thiol compound.

The composition was cured and tested in a RT-DMA measurement. Results are shown in Table 1.

### Example 12 - Thiol-ene composition containing the oligomer of Example 2 with a tetrathiol

A thiol-norbornene coating was prepared, by mixing the following materials:

| | |
|---|---|
| [PPG 2000 (IPDI-HEA-NB)₂] | 10.9 g (91.1 wt%) |
| Pentaerythritol tetrakis(3-mercapto propionate) | 0.95 g (7.9 wt%) |
| Irgacure 184 | 0.12 g (1.0 wt%) |

The composition was cured and tested in a RT-DMA measurement. Results are shown in Table 2.

### Example 13 - Thiol-ene composition with high modulus

A thiol-norbornene coating was prepared, by mixing the following materials:

| | |
|---|---|
| [PTGL 2000 (IPDI-HEA-NB)₂] | 1.06 g (14.7 wt%) |
| EBDN | 4.0 g (55.4 wt%) |
| Trimethylolpropane tris(3-mercapto propionate) | 2.01 g (27.9 wt%) |
| Irgacure 184 | 0.14 g (2.0 wt%) |

EBDN is ethoxylated bisphenol-A-dinorbornene and can be synthesised as described in Example 4 of PCT/US87/02618. A film was cured with UV light and post-baked at 80°C for 2hr.

Results from DMA and tensile testing are given in Table 4.

### Example 14 - Thiol-ene composition with high modulus

A thiol-norbornene coating was prepared as in example 13, but instead of 2 g TMPTSH, 1.85 g (26.2 wt%) of pentaerythritol tetrakis (3-mercaptopropionate) was used. A film was cured with UV light and post baked at 80°C for 2hr.

Results form DMA and tensile testing are given in Table 4.

### Comparative Experiment A - Acrylate composition containinq oligomer PTGL2000-(IPDI-HEA)₂

An acrylate coating composition was prepared, by mixing the following materials:

| | |
|---|---|
| [PTGL 2000 (IPDI-HEA)₂] | 10g (49.5 wt.%) |
| Di(ethyleneglycol)-2-ethyl hexyl acrylate (DEGEHA) | 10 g (49.5 wt.%) |
| Irgacure 184 | 0.202 g (I.00 wt.%) |

The composition was cured and tested in a RT-DMA and RT-IR measurement. The composition showed a slower modulus build-up than Example 6 (see Figure 1). Other results are shown in Table 3.

### Comparative Experiment B - Acrvlate composition containing oligomer PPG2000-(IPDI-HEA)₂

An acrylate coating composition was prepared, by mixing the following materials:

| | |
|---|---|
| [PPG 2000 (IPDI-HEA)₂] | 10g (49.5 wt.%) |
| Ethoxylated nonylphenol acrylate (ENPA) | 10 g (49.5 wt.%) |
| Irgacure 184 | 0.202 g (1 wt.%) |

The composition was cured and tested in a RT-DMA and RT-IR measurement. The composition showed a relatively fast modulus build-up (see Figure 2), but this is at the expense of a higher modulus. Other results are shown in Table 2.

### Comparative Experiment C - Acrylate composition containing oligomer PPG4200-(IPDI-HEA)₂

An acrylate coating coposition was prepared, by mixing the following materials:

| | |
|---|---|
| [PPG 4200 (IPDI-HEA)₂] | 10g (49.5 wt.%) |
| Ethoxylated nonylphenol acrylate (ENPA) | 10 g (49.5 wt.%) |
| Irgacure 184 | 0.202 g (I.00 wt.%) |

The composition was cured and tested in a RT-DMA and RT-IR measurement. The composition showed an even slower modulus build-up than the composition of Comparative Experiment B (see Figures 2 and 3). Other results are shown in Table 1.

### Comparative Experiment D - Thiol-ene composition containing oligomer PPG2000-(AA-NB)₂

### Synthesis of Polypropyleneglycol Dinorbornene ester (PPG2000(AA-NB)2)

Polypropyleneglycol2000 diacrylate 30g (0.0142mol) was stirred at room temperature under a nitrogen atmosphere in a 250 mL three-necked round-bottomed flask equipped with an efficient condenser, a constant pressure addition funnel, and a thermometer. Freshly cracked cyclopentadiene monomer 2.82g (0.0427mol, 3 equivalents) was added dropwise. The reaction mixture was then slowly raised to 80°C and stirred for 16h at 80°C. Finally excess cyclopentadiene and dicyclopentadiene were removed by vacuum system (0.5-2 mbar, below 70°C), quantitative yield pale yellow resin was obtained. The reaction was followed by FT-IR and ¹H NMR measurement and showed the conversion to be complete.
FT-IR (neat): 3061.1, 711.3 cm⁻¹(double bond of norbornene)
¹H NMR (CDCI₃, ppm): 1.15 (-CHCH₃), 3.4 (-CH₂O), 3.57 (-CHCH₃), 5.95, 6.12, 6.17 (*endo* and *exo hydrogen of norbornene double bonds*)

The compound so obtained can be represented by the following chemical structure: 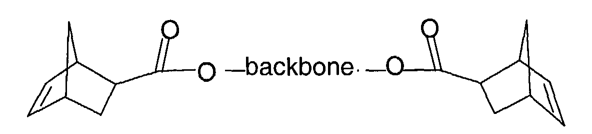 wherein the backbone is PPG2000.

The compound has a theoretical number average molecular weight Mn of 2240 and will be further referred to by PPG2000-(AA-NB)₂. The compound is analogous to the compound of Example 7 of WO 95/00869 (Loctite Corporation), except that polypropylene glycol with a molecular weight of 2000 has been used as the polyol instead of hydroxy terminated polytetramethylene oxide with a molecular weight of 650.

A thiol-norbornene coating composition was prepared, by mixing the following materials:

A thiol-norbornene coating composition was prepared, by mixing the following materials:

| | |
|---|---|
| [PPG 2000 (AA-NB)₂] | 10g (88.47 wt.%) |
| Trimethylolpropane tris(3-mercapto-propionate) | 1.19g (10.53 wt.%) |
| Irgacure 184 | 0.113g (1.00 wt.%) |

The molar ratio of ene to thiol is 1:1.

The composition was cured and tested in a RT-DMA and RT-IR measurement. The composition showed an even slower modulus build-up than the composition of Comparative Experiment C (see Figure 3). Other results are shown in Table 2.

### Comparative Experiment E - Thiol-ene composition containing oligomer PPG2000-(IPDI-CH₂-NB)₂

Synthesis of PPG2000-Di-(Norborn-2-ene-5-methylol) urethane 0.5 g of Irganox 1035, 83 g of IPDI and 0.3 of DBTDL (dibutyltindilaureate) were fed into a 1 L double walled reactor with water cooling/heating and equipped with an upper stirrer, dry-air-inlet, thermocouple and a dropping funnel. The mixture was cooled 10 10°C with strirring and dry airflow over the liquid 46.4 grams of 5-norbornene-2-methanol was added through the dropping funnel in 25 minutes and a high viscous, white mixture was obtained. After 1 hour the temperature was raised to 20°C and 370 g Desmophen 2061 BD (polypropyleneglycol with a molecular weight of 2000; OH number is 56.6) was added after which the reaction temperature was increased to 80°C. Regularly samples were taken for measuring the NCO content and the reaction was allowed to proceed untill the NCO content was below 0.05 wt%. This was reached after appr. 15 hours and the reaction mixture was poured out of the reactor.

The compound so obtained can be represented by the following chemical structure: 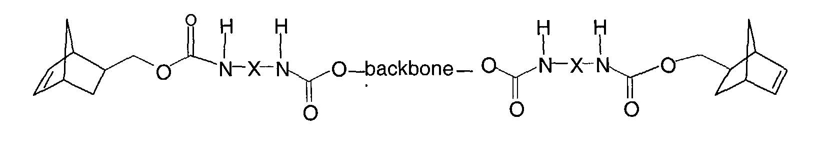 wherein the backbone is PPG2000, X is derived from IPDI and n equals1. The compound has a theoretical number average molecular weight Mn of 2693 and will be further referred to by PPG2000-(IPDI-CH₂-NB)₂.

A thiol-norbornene coating composition was prepared, by mixing the following materials:

| | |
|---|---|
| [PPG 2000 (IPDI-NB)₂] | 20g (90.12 wt.%) |
| Trimethylolpropane tris(3-mercapto-propionate) | 1.97 g (8.88 wt.%) |
| Irgacure 184 | 0.222g (1.00 wt.%) |

The composition was cured and tested in a RT-DMA and RT-IR measurement. The composition showed an even slower modulus build-up than the composition of Comparative Experiment D (see Figure 3). Other results are shown in Table 2.

### Comparative experiment F (reproduction of Loctite compound 1)

Hydroxyl-terminated PPG Poly(propyleneglycol 2000) (0.02495 mol OH) was stirred under a nitrogen atmosphere with 0.05g dibutyltin dilaurate in 250 mL round-bottomed flask equipped with an efficient condenser and a thermometer. Norborn-2-ene-5-isocyanate 4.432g (76% solution in toluene, 1.03 equivalents, made according to Jacobine, J. of App. Polym. Sci. Vo1.45, 471-485(1992) was added dropwise by syringe. During the addition, the reaction temperature was controlled under 30°C. After addition, the reaction temperature was raised slowly to 70°C and stirred for 4 hours. Then, toluene and excessive norborn-2-ene-5-isocyanate were removed under vacuum (0.5-2 mbar, below 70°C), a slightly yellow resin was yielded quantitatively. Analysis of the reaction mixture by FT-IR and ¹H NMR showed the conversion to be complete. Nevertheless, the resin had a strong odour, which remained in the coating composition, making it unsuitable for practical use.
FT-IR (neat, cm⁻¹): 1717 (urethane carbonyl), 3061.1, 722 (double bond of norbornene)
¹H NMR (CDCI₃, ppm): 1.09 (-CHCH₃), 3.34 (-CH₂O), 3.51 (-CHCH₃), 5.95, 6.01,6.09, 6.3 (*endo* and *exo* hydrogens of norbornene double bonds)]

**Table 1:**

| Resins with a backbone of PPG 4200 | | | | | |
|---|---|---|---|---|---|
| | | RT-DMA | | | RT-IR |
| | | G'[10⁵ Pa] (final modulus) | Cure time [s] till 10% of final modulus | Cure time [s] till 90% of final modulus | Rp* (%.s⁻¹) |
| 8 | PPG4200-IH-NB/TMPTSH | 2.0 ± 0.2 | 0.9 | 5.9 | 384 |
| 11 | PPG4200-IH-NB/TTLSH | 1.3 ± 0.1 | 0.6 | 8.1 | Nd |
| C | PPG4200-IH/ENPA | 3.9 ± 0.3 | 1.7 | 10.7 | 91 |

| | | | | | |
|---|---|---|---|---|---|
| * Rp - maximum rate of polymerisation %.s⁻¹ with respect to. unsaturation (ene) consumption | | | | | |

**Table 2:**

| Resins with a backbone of PPG 2000 | | | | | | |
|---|---|---|---|---|---|---|
| | | RT-DMA | | | RT-IR | |
| | | G'[10⁵Pa] (final modulus) | Cure time [s] 10% of final modulus | Cure time [s] 90% of final modulus | Rp (%.s⁻¹) | Gel time (s) |
| 7 | PPG2000-I-HEANB/TMPTSH | 4.5 ± 0.5 | 1.5 | 16.4 | 187 | 1.21 |
| 9 | PPG2000-I-HPANB/TMPTSH | 3.7 ± 0.4 | 1.9 | 30.4 | | 1.47 |
| 10 | PPG2000-I-HBANB/TMPTSH | 4.3 ± 0.4 | 1.5 | 18.1 | | 1.11 |
| 12 | PPG2000-I-HEANB/PETMP | 7.6 | 1.2 | 12.2 | | 0.80 |
| B | PPG2000-IH/ENPA | 7.2 ± 0.6 | 1.4 | 9.1 | 99 | - |
| D | PPG2000-AANB/TMPTSH | 3.7 ± 0.3 | 2.2 | 8.6 | | 1.7 |
| E | PPG2000-I-CH₂NB/TMPTSH | 4.6 ± 0.4 | 5.0 | 33.3 | | 5.2 |

**Table 3:**

| Resins with a backbone of PTGL, (curing irradiance 1.5 mW/cm² in RT DMA) | | | | | |
|---|---|---|---|---|---|
| | | RT-DMA | | | RT-IR |
| | | G'[10⁵Pa] (final modulus) | Cure time [s] 10% of final modulus | Cure time [s] 90% of final modulus | Rp (%.s⁻¹) |
| 6 | PTGL2000-IH-NB/TMPTSH | 8.7 ± 0.5 | 8.1 | 42.2 | 207 |
| A | PTGL2000-H/DEGEHA | 8.9 ± 0.5 | 9.8 | 40.3 | 44 |

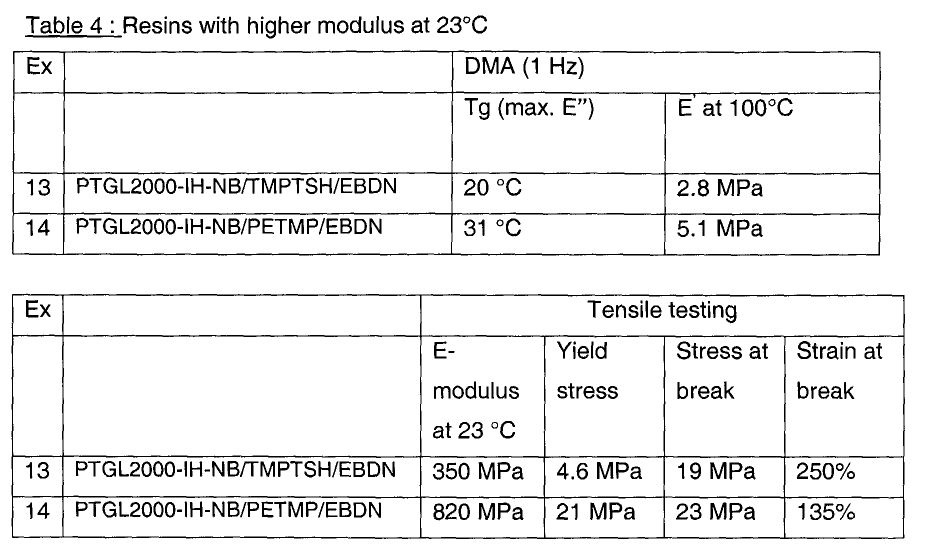

From the examples and comparative experiments, the following observations and conclusions can be drawn, as elucidated in the figures.

### Detailed description of the figures

Figure 1 shows the RT-DMA curves of Example 6 vs comparative Experiment A (see also table 3). The figure clearly shows that the Example 6 composition is significantly faster than the acrylate system. As is clear from table 3, the rate of polymerisation of the composition of Example 6 is much faster than that of comparative Experiment A.

Figure 2 shows the RT-DMA curves of Example 7 vs comparative Experiments B and C. Comparative Experiment B and Example 7 use the same backbone (PPG2000). The acrylate based system has a comparable rate of modulus build-up, however it cures to a two times higher modulus; i.e. a much higher cross link density. (Nevertheless, the Rp is significantly lower, see table 2). The proper comparison between acrylate and thiol-ene systems for cure speed is to look at a composition giving the same modulus. Hence, the comparison of Example 7 and comparative Experiment C is proper, and this comparison shows, that in RT-DMA, the thiol-ene system of the present invention is much faster. Experiment B can be compared with Example 12 (which uses a higher functional thiol); Example 12 is substantially faster than comparative Experiment B in RT-DMA.

Figure 3 shows again Example 7 and comparative Experiment C. It furthermore shows comparative Experiment D, which appears to be even slower than the acrylate based system. Comparative Experiment E is yet even slower. These experiments show, that the specific compositions of the present invention have unexpectedly high cure speed.

### Description of test methods

### Determination of the speed of network formation by Real-Time DMA ("RT-DMA")

The primary instrument is a Rheometric Scientific RDA-2 rheometer, equipped with a 200 g*cm and 2000 g*cm dual range torque transducer. The conventional steel parallel plate system was replaced by custom made plate holders equipped with two quartz discs with a diameter of 9.5 mm, allowing UV light to illuminate the sample from the top.

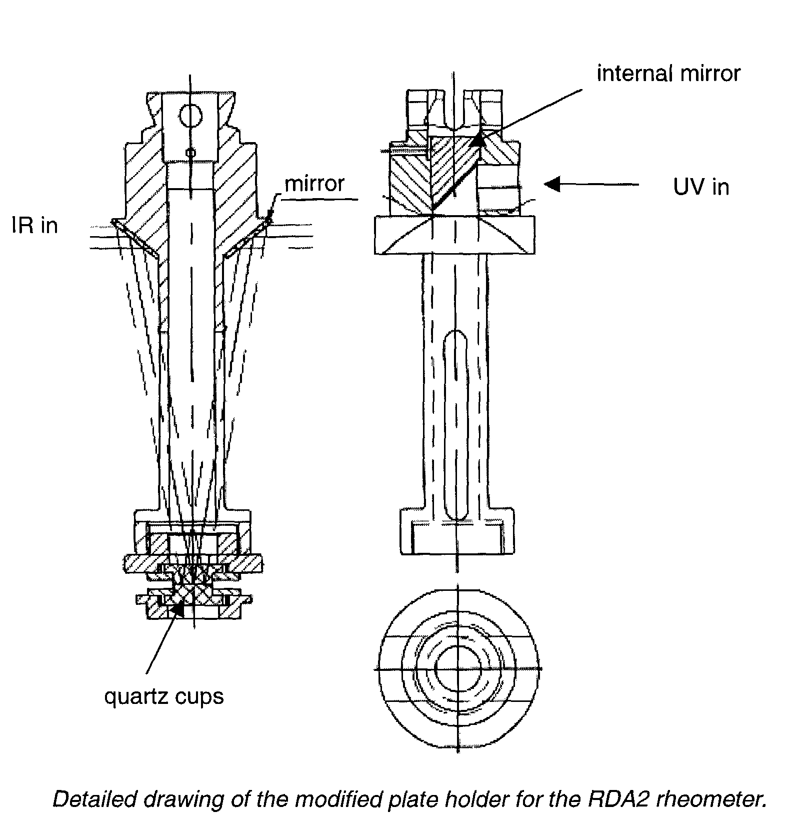

A mirror is mounted internally in the upper plate holder reflecting the UV light emitted by an external UV source to the sample. (Path was not used in the experiments reported here)

UV light was obtained from a Bluepoint-2 UV source, manufactured by the Dr. Hönle Company based in Germany. The UV lamp is an F- type bulb that contains not only mercury, but also iron halides within the bulb, changing the spectral output to closely resemble the types of UV lamps that are used in the fiber optics industry. Light from the lamp was conveyed to the plate holder by use of a flexible liquid-filled light guide.

The intensity (irradiance) of the UV light was measured below the upper quartz plate (before a sample was put in) with a Solascope 1 radiometer manufactured by Solatell. An irradiance of about 28 mW/cm² was detected. [For PTGL systems, an irradiance of about 1.5 mW/cm² was used].

After preliminary setup steps, the sample was loaded into the rheometer and the upper quartz plate was lowered towards the lower quartz plate until a gap of 0.1 mm was established. Excess liquid was trimmed from the sample so that the sample size would be exactly 9.5 mm in diameter and 0.1 mm thick. Then the oven doors were closed and a purging flow of nitrogen gas started. Purging with nitrogen was continued for at least five minutes. The purpose of nitrogen purging is to prevent oxygen inhibition of curing of the acrylate samples at or near the sample edges which would occur in an air atmosphere, and to not need removing dissolved oxygen from the sample, which would take much longer.

For the cure test, the instrument was operated in the so-called arbitrary wave mode. A time sweep measurement was performed (by keeping the frequency, amplitude and temperature fixed and following the changes in material properties). A sinusoidal wave, with the following parameters set/fixed: angular frequency 52.36 rad/s and strain amplitude of 10%, with a duration of 64 seconds was programmed. Data sampling of the torque and strain signals was set to 4 intervals of 16 seconds duration, each sampling 400 data-points. This results in three data points for both stress and strain per cycle. Additionally, plate diameter and sample thickness are entered. The measurement temperature was set to 23°C.

When a measurement run was started, data collection started automatically after download of the sinusoidal waveform to the rheometer. Upon start of the measurements a controller box is triggered which opens the shutter in the Bluepoint-2 after a fixed delay of 1.575 s into the run. UV illumination was continued for 60 seconds after the shutter was triggered.

Upon completion of a run, the stress and strain data are transformed into dynamic shear modulus and phase angle via the Discrete Fourier Transformation utility of the RSI Orchestrator (version 6.5.8) software package from Rheometric Scientific. For this purpose we selected the magnitude and phase mode of the utility and set it to three data points per period. As a result we obtain the curves of the dynamic shear modulus G* and the phase angle δ as a function of cure time. The time axis was corrected for the delay introduced by the controller box by subtracting the fixed delay (1.575 s) from the time data. Modulus and phase angle are corrected for the instrument phase delay (18.3 degrees at the measurement frequency chosen) and the conversion from strain percentage strain to actual strain. In a RT-DMA measurement, which is a dynamic measurement, the following moduli are measured: the storage shear modulus G', the loss shear modulus G", and the dynamic shear modulus G* according to the following relation G* = (G'² + G"²)^{1/2}. Further, the phase angle δ relates to the shear moduli as follows: tan δ = G"/G'.

Typically, after the start of the UV illumination, the storage shear modulus G' shows a fast monotonous increase and levels off when full cure is obtained. Simultaneously, the phase angle drops from typical liquid values (around 90 degrees) to typical elastic values (around 0 degrees). For final analysis, the data were exported into Microsoft Excel.

From the data we select the value of the storage shear modulus G' (the product of the dynamic shear modulus and the cosine of the phase angle) at the end of the cure cycle (after 60 seconds UV-illumination) as the value for the final network modulus of the material. [This, is further called the "end storage shear modulus"(G')]. Usually, full cure is obtained within 64 seconds cure cycle.

As a measure for the speed of network formation we extract the time at which the storage shear modulus has increased to a certain fraction of the final modulus.

In the present application, we use the time it takes for the storage shear modulus to increase to 10% of the value after 64 seconds cure as indication for the speed of network formation.

### RT FTIR measurements

### Real time determination of chemical conversions by rapid scan FTIR

The real time chemical conversion for UV curable acrylate and thiolene coatings were determined using rapid scan FTIR. A Bruker IFS 55 was equiped with a horizontal transflection cell and an MCT detector. A UV source, a Bluepoint 2 system with a D-bulb, was coupled using a quartz light guide into the cell focused on the sample. The light intensity was 41.0 ± 1.0_mW/cm² The UV source system was equipped with an electronic shutter. (For a schematic setup of the equipment see: A.A. Dias, H.Hartwig, J.F.G.A. Jansen, Real time FT-IR for both liquid and radiation curable powder systems, Surface Coating International 2000, August 2000, 83(8) p384).

A 20 micron thick layer of the reactive composition on a gold coated Alumina plate (7 X 7 mm) was cured under a nitrogen atmosphere and at room temperature. The actual film thickness was adjusted by placing the sample in the FTIR cell, recording a spectrum and checking the absorbance of the functional groups specific IR band. Thickness of the film was adjusted until the absorbances were between 0.2 and 0.6.

The infrared spectrum of the uncured, liquid sample was obtained. The sample was then cured by exposure to UV. During curing full FTIR spectra were recorded with a maximum speed of 25 spectra/s with decreasing acquisition rate. Finally an infrared spectrum of the cured resin was recorded after the shutter blocked the UV light.

The net peak heights were calculated of the functional group specific IR bands of acrylate (1635 cm⁻¹), norbornene (3060 cm⁻¹) and thiol (2555 cm⁻¹) in each recorded FTIR spectrum. The net peak area can be determined using the baseline technique in which a baseline is drawn tangent to absorbance minima near the peak. The difference in absorbance between the peak and the baseline is the net peak height. The experiment was performed in duplicate.

The maximum rate of polymerisation was determined as described by Dias et al (see ref above) and reported as %/s.

To compare amongst thiol-ene systems, which polymerise in a second order reaction, the gel-point at the critical ene conversion according to classic Flory-Stockmayer theory of gelation was used (previously described by B-S Chiou and S.A. Khau Marcomolecules 1997 30, 7322-7328). A plot of 1/(1-X) where X is conversion (in fraction) increased linearly with time up to the gel point where upon the slope of the line changes. In order to compare the point of deflection, the ultimate rate of conversion was set at 94% (a normalised value).

DMA and tensile measurements were performed as described in WO 02/42237, which is hereby incorporated by reference.

## Claims

1. A curable thiol-ene composition comprising either compound A and compound B, or a compound B further comprising polythiol functionality as defined under (A), wherein
(A) a polythiol,
(B) a compound having a plurality of cyclic ene groups thereon, wherein said compound (B) comprises a carbonyl group directly attached to at least one cyclic ene group and comprises at least one hydrogen donating group, wherein the distance between at least one of said cyclic ene groups and at least one of said hydrogen donating groups is at least two skeletal bonds, and
(C) 0-10 wt.% of a photoinitiator.

2. The composition according to claim 1 wherein the functionality of both compound A and B are higher than 1.2 on average, and wherein the functionality of A + B is about 4 or higher.

3. The composition according to any one of claims 1-2 wherein either component A or B contains a backbone.

4. The composition according to any one of claims 1-3 wherein the polythiol (A) is an ester of a thiol-carboxylic acid compound.

5. The composition according to any one of claims 1-4 wherein the at least one hydrogen donating group is selected from the group consisting of hydroxy, amino, thiol, carboxyl.

6. The composition according to claim 5 wherein the hydrogen donating group is selected from the group consisting of urethane, inverted urethane, urea, amide, thio-urethane, thiourea, isothiourea, hydroxy esters and hydroxy.

7. The composition according to any one of claims 1-6 wherein the cyclic ene group has a fused ring structure.

8. The composition according to any one of claims 1-7 wherein component A or B comprises 4 or more urethane bonds and a backbone.

9. The composition of any one of claims 1-8 wherein the molecular weight of the component comprising a backbone has a molecular weight of 250 to 6000.

10. The composition of any one of claims 1-9, wherein the distance between at least one of said cyclic ene groups and at least one of said hydrogen donating groups is at least two carbon skeletal bonds.

11. The composition according to any one of claims 1-10, wherein compound A and B are distinct compounds.

12. The composition according to any of claims 1-10, wherein (A) and (B) are combined in one compound.

13. The composition according to any one of claims 1-12 wherein the composition further comprises diluents or oligomers with one or more ene groups different from compound B.

14. Optical glass fiber coating composition comprising a curable composition according to any one of claims 1-13.

15. Optical glass fiber coating composition according to claim 14 suitable for use as a primary coating, secondary coating, ink, matrix, bundling or upjacketing coating material.

16. Primary coating for coating optical glass fibers comprising a curable composition according to any one of claims 1-13, said coating after cure having an (E') equilibrium modulus of 0.3-3 MPa.

17. A curable resin composition for use in photofabrication (stereolithotography) comprising a composition according to any one of claims 1-13.

18. A product obtained by curing the composition according to anyone of claims 1-13.

19. A product according to claim 18, wherein the product is a functional prototype.

20. A product according to claim 18, wherein the product is a coating.

21. A process for obtaining a coating or a product, which process comprises the step of curing a composition according to any one of claims 1-13 with EB, UV, or UV-vis radiation.

22. A compound having a plurality of cyclic ene groups thereon, wherein said compound comprises a carbonyl group directly attached to at least one cyclic ene group and comprises at least one hydrogen donating group, wherein the distance between at least one of said cyclic ene groups and at least one of said hydrogen donating groups equals at least two skeletal bonds.

23. A compound according to claim 22, said compound further comprising thiol groups.
